# EUROPÄISCHE PATENTANMELDUNG

(11) **EP 3 163 733 A1**
(43) Veröffentlichungstag der Anmeldung: **03.05.2017**
(21) Anmeldenummer: 16192623.3
(22) Anmeldetag: 06.10.2016
(51) Int. Cl.: H02M 1/32, H02M 7/538, H03K 17/08, H03K 17/082

(54) **WECHSELEINRICHTER FÜR EINE ELEKTRISCHE MASCHINE, ELEKTRISCHE ANTRIEBSEINRICHTUNG FÜR EIN KRAFTFAHRZEUG SOWIE VERFAHREN ZUM BETREIBEN EINES WECHSELRICHTERS**

(30) Priorität: 28.10.2015 DE 102015013875
(71) Anmelder: AUDI AG, 85045 Ingolstadt (DE)
(72) Erfinder: Rechberger, Klaus, 71638 Ludwigsburg (DE); Wischerath, Jan, 85055 Ingolstadt (DE)

(57) **Zusammenfassung**

Die Erfindung betrifft einen Wechselrichter (3) für eine elektrische Maschine (2), der einen über einen ersten elektrischen Pol (6) und einen zweiten elektrischen Pol (7) verfügenden Zwischenkreis (4) aufweist und über mehrere Phasensystemen (11,12,13) verfügt, die jeweils eine High Side-Schalteinrichtung (14,18,22) und eine Low Side-Schalteinrichtung (16,20,24) aufweisen, wobei die High Side-Schalteinrichtung (14,18,22) einerseits an den ersten Pol (6) und andererseits an die Low Side-Schalteinrichtung (16,20,24) angeschlossen und die Low Side-Schalteinrichtung (16,20,24) einerseits an die High Side-Schalteinrichtung (14,18,22) und andererseits an den zweiten Pol (7) angeschlossen ist, wobei die High Side-Schalteinrichtung (14,18,22) und die Low Side-Schalteinrichtung (16,20,24) jeweils einen Leistungsschalter (15,17,19,21,23,25) mit einem Schalteingang (28), einem Leistungseingang (29) und einem Leistungsausgang (30) aufweisen, und wobei der Leistungseingang (29) und der Leistungsausgang (30) bei geschlossenem Leistungsschalter (15,17,19,21,23,25) elektrisch miteinander verbunden und bei geöffnetem Leistungsschalter (15,17,19,21,23,25) elektrisch getrennt sind. Dabei ist vorgesehen, dass der Schalteingang (28) des Leistungsschalters (15,17,19,21,23,25) der High Side-Schalteinrichtung (14,18,22) und/oder der Low Side-Schalteinrichtung (16,20,24) sowohl an eine Steuerschaltung (31) als auch an eine Zwischenkreisspannungsbegrenzungsschaltung (32) angeschlossen ist, die den Leistungsschalter (15,17,19,21,23,25) beim Überschreiten eines Spannungsgrenzwerts durch eine Zwischenkreisspannung in dem Zwischenkreis (4) schließt. Die Erfindung betrifft weiterhin eine elektrische Antriebseinrichtung für ein Kraftfahrzeug sowie ein Verfahren zum Betreiben eines Wechselrichters (3) für eine elektrische Maschine (2).

## Beschreibung

Die Erfindung betrifft einen Wechselrichter für eine elektrische Maschine, der an einen über einen ersten elektrischen Pol und einen zweiten elektrischen Pol verfügenden Zwischenkreis angeschlossen ist und über mehrere Phasensystemen verfügt, die jeweils eine High Side-Schalteinrichtung und eine Low Side-Schalteinrichtung aufweisen, wobei die High Side-Schalteinrichtung einerseits an en ersten Pol und andererseits an die Low Side-Schalteinrichtung angeschlossen und die Low Side-Schalteinrichtung einerseits an die High Side-Schalteinrichtung und andererseits an den zweiten Pol angeschlossen ist, wobei die High Side-Schalteinrichtung und die Low Side-Schalteinrichtung jeweils einen Leistungsschalter mit einem Schalteingang, einem Leistungseingang und einem Leistungsausgang aufweisen, und wobei der Leistungseingang und der Leistungsausgang bei geschlossenem Leistungsschalter elektrisch miteinander verbunden und bei geöffnetem Leistungsschalter elektrisch getrennt sind. Die Erfindung betrifft weiterhin eine elektrische Antriebseinrichtung für ein Kraftfahrzeug sowie ein Verfahren zum Betreiben eines Wechselrichters für eine elektrische Maschine.

Die elektrische Maschine dient beispielsweise dem Antreiben des Kraftfahrzeugs, insoweit also dem Bereitstellen eines auf das Antreiben des Kraftfahrzeugs gerichteten Drehmoments. Weil ein Bordnetz des Kraftfahrzeugs üblicherweise lediglich einen Gleichstrom bereitstellt, die elektrische Maschine jedoch vorzugsweise als Wechselstrommaschine beziehungsweise Drehstrommaschine vorliegt, ist der Wechselrichter vorgesehen. Der Wechselrichter dient dazu, den Gleichstrom in Wechselstrom beziehungsweise Drehstrom umzusetzen. Der Wechselrichter liegt beispielsweise in Form eines Pulswechselrichters oder als Vierquadrantensteller vor.

Der Wechselrichter weist den Zwischenkreis auf oder ist zumindest an diesen angeschlossen. Der Zwischenkreis verfügt über den ersten elektrischen Pol und den zweiten elektrischen Pol, welche voneinander verschiedene elektrische Potentiale aufweisen. Beispielsweise liegt der erste elektrische Pol als Pluspol und der zweite elektrische Pol als Minuspol vor. Der Wechselrichter weist zudem die mehreren Phasensysteme auf, also zumindest zwei Phasensysteme (im Falle einer Umsetzung des Gleichstroms in Wechselstrom) oder zumindest drei Phasensysteme (für eine Umsetzung in Drehstrom). Jedes der Phasensysteme verfügt jeweils über eine High Side-Schalteinrichtung und eine Low Side-Schalteinrichtung auf, welche miteinander in Reihe und einerseits an den ersten elektrischen Pol und andererseits an den zweiten elektrischen Pol angeschlossen sind.

Anders ausgedrückt ist also die High Side-Schalteinrichtung einerseits an den ersten elektrischen Pol und andererseits an die Low Side-Schalteinrichtung angeschlossen, während die Low Side-Schalteinrichtung einerseits an die High Side-Schalteinrichtung und andererseits an den zweiten elektrischen Pol angeschlossen ist. Jede der Schalteinrichtungen, also sowohl die High Side-Schalteinrichtung als auch die Low Side-Schalteinrichtung, verfügt jeweils über einen Leistungsschalter, der den Schalteingang, den Leistungseingang und den Leistungsausgang aufweist. Liegt an dem Schalteingang eine Spannung an oder fließt ein elektrischer Strom von dem Schalteingang zu dem Leistungsausgang, so schließt der Leistungsschalter, sodass der Leistungseingang mit dem Leistungsausgang elektrisch verbunden ist. Ist dagegen der Schalteingang spannungslos beziehungsweise stromlos, so ist der Leistungsschalter geöffnet und entsprechend sind der Leistungseingang und der Leistungsausgang elektrisch voneinander getrennt.

Der Leistungsschalter liegt beispielsweise als Transistor, insbesondere als Bipolartransistor oder als Feldeffekttransistor vor. Der Feldeffekttransistor kann dabei als Bipolartransistor mit isolierter Gateelektrode (IGBT) ausgestaltet sein, der Feldeffekttransistor als Sperrschicht-Feldeffekttransistor oder als Metall-Isolator-Halbleiter-Feldeffekttransistor (MISFET) beziehungsweise als Feldeffekttransistor mit einem durch einen Isolator getrennten Gate (IGFET) ausgestaltet sein. Selbstverständlich kann der Leistungsschalter jedoch auch eine hierzu alternative Ausgestaltung aufweisen.

Die vorstehenden Ausführungen konkretisierend ist der Leistungseingang des Leistungsschalters der High Side-Schalteinrichtung permanent mit dem ersten elektrischen Pol verbunden, während sein Leistungsausgang permanent mit dem Leistungseingang des Leistungsschalters der Low Side-Schalteinrichtung verbunden ist. Der Leistungsausgang des Leistungsschalters der Low Side-Schalteinrichtung wiederum ist permanent mit dem zweiten elektrischen Pol verbunden. Zwischen der High Side-Schalteinrichtung und der Low Side-Schalteinrichtung kann nun ein Phasenanschluss für die elektrische Maschine vorgesehen sein, insbesondere ist ein elektrischer Anschluss der elektrischen Maschine zwischen der High Side-Schalteinrichtung und der Low Side-Schalteinrichtung angeschlossen.

Es ist nun Aufgabe der Erfindung, einen Wechselrichter für eine elektrische Maschine vorzuschlagen, welche gegenüber bekannten Wechselrichtern Vorteile aufweist, insbesondere auch im Fehlerfall zuverlässig betrieben werden kann.

Dies wird mit einem Wechselrichter mit den Merkmalen des Anspruchs 1 erreicht. Dabei ist vorgesehen, dass der Schalteingang des Leistungsschalters der High Side-Schalteinrichtung und/oder der Low Side-Schalteinrichtung sowohl an eine Steuerschaltung als auch an eine Zwischenkreisspannungsbegrenzungsschaltung angeschlossen ist, die den Leistungsschalter beim Überschreiten eines Spannungsgrenzwerts durch eine Zwischenkreisspannung in dem Zwischenkreis schließt. Die Steuerschaltung ist beispielsweise ein Steuergerät des Wechselrichters und dient der entsprechenden Ansteuerung der High Side-Schalteinrichtungen und der Low Side-Schalteinrichtungen zur Bereitstellung des Wechselstroms beziehungsweise Drehstroms aus dem Gleichstrom des Zwischenkreises.

Die Zwischenkreisspannungsbegrenzungsschaltung ist dagegen zur Begrenzung der Zwischenkreisspannung mithilfe des Wechselrichters vorgesehen. Vorzugsweise ist jeder Schalteingang der Leistungsschalter aller High Side-Schalteinrichtungen oder aller Low Side-Schalteinrichtungen jeweils einerseits an die Steuerschaltung und andererseits an die Zwischenkreisspannungsbegrenzungsschaltung angeschlossen. Jedem Leistungsschalter der High Side-Schalteinrichtungen beziehungsweise der Low Side-Schalteinrichtungen ist insoweit vorzugsweise jeweils eine derartige Zwischenkreisspannungsbegrenzungsschaltung zugeordnet.

Wird die elektrische Maschine als Generator betrieben und der Wechselrichter entsprechend angesteuert, so dient der Wechselrichter dem Gleichrichten des von der elektrischen Maschine erzeugten Wechselstroms beziehungsweise Drehstroms. Wird dieser jedoch in dem Zwischenkreis nicht benötigt, beispielsweise weil ein Energiespeicher von dem Zwischenkreis abgekoppelt ist, insbesondere aufgrund eines Defekts des Energiespeichers, oder weil ein an den Zwischenkreis angeschlossenes Bordnetz des Kraftfahrzeugs nur eine geringere Menge an elektrischem Strom benötigt, so kann es zu einem deutlichen Spannungsanstieg in dem Zwischenkreis kommen.

Um eine Beschädigung des Wechselrichters und/oder des Bordnetzes beziehungsweise einzelner Komponenten von diesen zu verhindern, ist die Zwischenkreisspannungsbegrenzungsschaltung vorgesehen. Sobald die Zwischenkreisspannungsbegrenzung feststellt, dass die in dem Zwischenkreis vorliegende Zwischenkreisspannung den Spannungsgrenzwert überschreitet, schließt sie den ihr zugeordneten Leistungsschalter, sodass dieser elektrisch durchgängig wird und entsprechend der Leistungseingang mit dem Leistungsausgang elektrisch verbunden ist. Ist die Zwischenkreisspannungsbegrenzungsschaltung der High Side-Schalteinrichtung zugeordnet, so kann bei Ansprechen der Zwischenkreisspannungsbegrenzungsschaltung und gleichzeitig geschlossenem Leistungsschalter der Low Side-Schalteinrichtung der erste elektrische Pol unmittelbar mit dem zweiten elektrischen Pol verbunden werden, sodass die in dem Zwischenkreis vorliegende elektrische Energie durch Kurzschließen der beiden Pole abgebaut und in Wärme umgesetzt wird.

Umgekehrt kann selbstverständlich die Zwischenkreisspannungsbegrenzungsschaltung der Low Side-Schalteinrichtung zugeordnet sein. In diesem Fall kann das beschriebene Vorgehen bei gleichzeitig geschlossenem Leistungsschalter der High Side-Schalteinrichtung durchgeführt werden. Vorzugsweise ist es daher vorgesehen, den Wechselrichter durchgehend zum Betreiben der elektrischen Maschine anzusteuern, also insbesondere als elektrischen Motor oder als elektrischen Generator zu betreiben. Entsprechend werden zumindest diejenigen Leistungsschalter der High Side-Schalteinrichtung beziehungsweise der Low Side-Schalteinrichtung, welchen keine Zwischenkreisspannungsbegrenzungsschaltung zugeordnet ist, periodisch geschlossen und wieder geöffnet. Daher kann über sie zumindest periodisch die elektrische Energie abgebaut werden.

Bevorzugt ist jedem Leistungsschalter eine separate Zwischenkreisspannungsbegrenzungsschaltung zugeordnet. Es kann jedoch auch vorgesehen sein, dass die Zwischenkreisspannungsbegrenzungsschaltung mehreren Leistungsschaltern zugeordnet ist, insbesondere allen Leistungsschaltern der High Side-Schalteinrichtungen oder der Low Side-Schalteinrichtungen. Bevorzugt liegt die Zwischenkreisspannungsbegrenzungsschaltung separat von der Steuerschaltung beziehungsweise dem Steuergerät vor. Insbesondere ist sie in die High Side-Schalteinrichtungen und die Low Side-Schalteinrichtungen integriert.

Es kann jedoch auch vorgesehen sein, dass die Zwischenkreisspannungsbegrenzungsschaltung der Steuerschaltung zugeordnet ist. Stellt diese fest, dass die Zwischenkreisspannung den Spannungsgrenzwert überschreitet, so kann es vorgesehen sein, dass die Steuerschaltung die Leistungsschalter sowohl der High Side-Schalteinrichtung als auch der Low Side-Schalteinrichtung wenigstens eines der Phasensysteme, vorzugsweise mehrerer der Phasensysteme oder aller Phasensysteme, schließt und entsprechend den ersten elektrischen Pol mit dem zweiten elektrischen Pol kurzschließt. Entsprechend dient der Wechselrichter dazu, über seine Phasensysteme die in dem Zwischenkreis vorliegenden Überspannung effizient abzubauen.

Die elektrische Maschine liegt vorzugsweise als Asynchronmaschine vor. Während es bei Synchronmaschinen, insbesondere permanenterregten Synchronmaschinen, vorgesehen sein kann, die elektrische Maschine mittels der Schalteinrichtungen kurzuschließen, was auch als aktiver Kurzschluss bezeichnet wird, ist dies bei der Asynchronmaschine nicht zulässig. Dies liegt darin begründet, dass durch das Kurzschließen der Asynchronmaschine ein hoher Kurzschlussstrom entsteht, der den Wechselrichter und/oder die elektrische Maschine zerstören kann. Dies wird mit der vorstehend beschriebenen Ausgestaltung des Wechselrichters verhindert. Zusätzlich kann es vorgesehen sein, dass der Wechselrichter in seinem Zwischenkreis einen sogenannten Bremschopper aufweist. Auch über diesen kann ein kontrolliertes Kurzschließen des ersten elektrischen Pols mit dem zweiten elektrischen Pol erfolgen. Hierzu sind jedoch zusätzliche Komponenten notwendig, was für den Wechselrichter gemäß dieser Beschreibung nicht in demselben Ausmaß der Fall ist.

Im Rahmen einer vorteilhaften Weiterbildung der Erfindung ist vorgesehen, dass die Zwischenkreisspannungsbegrenzungsschaltung eine Z-Diode und eine Diode aufweist, wobei eine Kathode der Z-Diode an den Leistungseingang und eine Anode der Z-Diode über die Diode an den Schalteingang des jeweiligen Leistungsschalters angeschlossen ist. Die Z-Diode kann auch als Zener-Diode bezeichnet werden. Die Z-Diode sowie die Diode sind miteinander in Reihe geschaltet, wobei sie einerseits an den Leistungseingang und andererseits an den Schalteingang des jeweiligen Leistungsschalters angeschlossen sind. Genauer gesagt ist die Kathode der Z-Diode an den Leistungseingang angeschlossen, während ihre Anode mit der Anode der Diode verbunden ist. Die Kathode der Diode wiederum ist an den Schalteingang des Leistungsschalters angeschlossen. Zusätzlich kann die Steuerschaltung an den Schalteingang beziehungsweise die Kathode der Diode angeschlossen sein.

Die Z-Diode und die Diode bilden zusammen eine sogenannte "Active Clamping"-Schaltung. Die Z-Diode weist eine bestimmte Zenerspannung beziehungsweise Durchbruchsspannung auf. Ist diese von der Zwischenkreisspannung erreicht oder überschritten, so wird die Z-diode durchgängig. Entsprechend wird der Schalteingang des entsprechenden Leistungsschalters mit einer Spannung beziehungsweise einem Strom beaufschlagt, sodass er schließt.

Im Rahmen einer weiteren Ausgestaltung der Erfindung ist vorgesehen, dass die Zenerspannung der Z-Diode dem Spannungsgrenzwert entspricht. Besonders vorteilhaft ist es selbstverständlich, wenn die Z-Diode verhindert, dass die Zwischenkreisspannung den Spannungsgrenzwert überschreitet. Aus diesem Grund wird die Z-Diode derart gewählt, dass ihre Zenerspannung gleich dem Spannungsgrenzwert ist. Alternativ kann die Zenerspannung geringfügig größer sein als der Spannungsgrenzwert, insbesondere mindestens 5 %, mindestens 10 %, mindestens 15 % oder mindestens 20 % größer.

Eine bevorzugte weitere Ausgestaltung der Erfindung sieht vor, dass dem Leistungsschalter eine Kapazität parallel geschaltet ist. Die Kapazität, also beispielsweise ein Kondensator, ist insoweit einerseits an dem Leistungseingang und andererseits an dem Leistungsausgang des Leistungsschalters angeschlossen. Die Kapazität arbeitet als Filter, insbesondere als Tiefpassfilter. Während eines normalen Betriebs des Wechselrichters kann über den Leistungsschalter eine kurzfristige Überspannung, auch als Kommutierungsüberspannung bezeichnet, auftreten. Diese tritt jedoch nur über einen Zeitraum von höchstens 10 ns bis höchstens 100 ns auf. Um zu verhindern, dass die Zwischenkreisspannungsbegrenzungsschaltung bereits aufgrund dieser (zulässigen) Überspannung den Leistungsschalter schließt, ist der Kondensator zur Filterung der über den Leistungsschalter anfallenden Spannung vorgesehen.

Eine Weiterbildung der Erfindung sieht vor, dass der Leistungsschalter einen Leistungstransistor und eine dem Leistungstransistor parallel geschaltete Diode aufweist. Der Leistungsschalter besteht insoweit aus mehreren Elementen, nämlich dem Leistungstransistor und der Diode. Diese entspricht jedoch nicht der vorstehend bereits erwähnten Diode, welche Bestandteil der Zwischenkreisspannungsbegrenzungsschaltung ist. Die Diode liegt als sogenannte Freilaufdiode vor.

Eine weitere bevorzugte Ausgestaltung der Erfindung sieht vor, dass der Zwischenkreis wenigstens einen Zwischenkreiskondensator aufweist, über den der elektrische Pol mit dem zweiten elektrischen Pol elektrisch verbunden ist. Insbesondere liegt die elektrische Verbindung zwischen den elektrischen Polen über den Zwischenkreiskondensator permanent vor. Der Zwischenkreiskondensator ist beispielsweise den Phasensystemen mit ihren High Side-Schalteinrichtungen und Low Side-Schalteinrichtungen parallel geschaltet. Der Zwischenkreiskondensator dient einer Spannungsglättung in dem Zwischenkreis. Es kann auch vorgesehen sein, dass mehrere Zwischenkreiskondensatoren vorgesehen sind, welche miteinander in Reihe geschaltet sind und die zwischen dem ersten elektrischen Pol und den zweiten elektrischen Pol vorliegen und an diese angeschlossen sind. Beispielsweise ist der erste elektrische Pol über einen ersten Zwischenkreiskondensator an einen zweiten Zwischenkreiskondensator angeschlossen, welcher andererseits an den zweiten elektrischen Pol angeschlossen ist. Die jeweils von den Polen abgewandten Seiten der Zwischenkreiskondensatoren können auf Masse gezogen sein.

Eine besonders bevorzugte Ausgestaltung der Erfindung sieht vor, dass das Schließen des Leistungsschalters aufgrund des Überschreitens des Spannungsgrenzwerts auf eine bestimmte Zeitspanne begrenzt ist. Durch das Schließen des Leistungsschalters beziehungsweise das gleichzeitige Schließen der Leistungsschalter der Low Side-Schalteinrichtung und der High Side-Schalteinrichtung fließt über die Leistungsschalter ein hoher Strom, beispielsweise in der Größenordnung von 1000 A oder 1500 A. Um eine Beschädigung der Leistungsschalter zu vermeiden, soll das Kurzschließen der beiden Pole über den Leistungsschalter nur über die bestimmte Zeitspanne vorgenommen werden. Diese ist vorzugsweise derart gewählt, dass auch bei einer hohen elektrischen Stromstärke keine Beschädigung des Leistungsschalters auftreten kann.

Schließlich kann in einer bevorzugten Ausgestaltung der Erfindung vorgesehen sein, dass eine Schließzeit des Leistungsschalters mittels der Steuerschaltung überwacht und/oder oder begrenzt ist. Vorstehend wurde bereits angedeutet, dass die Steuerschaltung und die Zwischenkreisspannungsbegrenzungsschaltung jeweils beide an den Leistungsschalter angeschlossen sind. Entsprechend kann es vorgesehen sein, dass die Steuerschaltung sensiert, ob die Zwischenkreisspannungsbegrenzungsschaltung den Leistungsschalter schließt. Wird dies festgestellt, so kann beispielsweise ein Timer gestartet werden.

Wird nun festgestellt, beispielsweise mit Hilfe des Timers, dass die vorstehend erwähnte bestimmte Zeitspanne seit dem Schließen des Leistungsschalters durch die Zwischenkreisspannungsbegrenzungsschaltung verstrichen ist, so kann es vorgesehen sein, dass die Steuerschaltung das Schließen beendet beziehungsweise den Leistungsschalter wieder öffnet. Dies kann beispielsweise geschehen, indem der Schalteingang des Leistungsschalters auf Masse gezogen wird, vorzugsweise über einen ausreichend dimensionierten Widerstand. Selbstverständlich kann es auch vorgesehen sein, dass die Steuerschaltung zum Begrenzen der Schließzeit des Leistungsschalters eine elektrische Verbindung zwischen der Zwischenkreisspannungsbegrenzungsschaltung und dem Leistungsschalter beziehungsweise dessen Schalteingang elektrisch unterbricht.

Die Erfindung betrifft weiterhin eine elektrische Antriebseinrichtung für ein Kraftfahrzeug, mit einer elektrischen Maschine und einem Wechselrichter zur Ansteuerung der elektrischen Maschine. Dabei soll der Wechselrichter gemäß den vorstehenden Ausführungen ausgestaltet sein. Auf die Vorteile einer derartigen Ausgestaltung der Antriebseinrichtung beziehungsweise des Wechselrichters wurde bereits hingewiesen. Sowohl der Wechselrichter als auch die elektrische Antriebseinrichtung können gemäß den vorstehenden Ausführungen weitergebildet sein, sodass insoweit auf diese verwiesen wird.

Die Erfindung betrifft schließlich ein Verfahren zum Betreiben eines Wechselrichters für eine elektrische Maschine, insbesondere eines Wechselrichters gemäß den vorstehenden Ausführungen, wobei der Wechselrichter an einen über einen ersten elektrischen Pol und einen zweiten elektrischen Pol verfügenden Zwischenkreis angeschlossen ist und mehrere Phasensysteme aufweist, die jeweils über eine High Side-Schalteinrichtung und eine Low Side-Schalteinrichtung verfügen, wobei die High Side-Schalteinrichtung einerseits an den ersten Pol und andererseits an die Low Side-Schalteinrichtung angeschlossen und die Low Side-Schalteinrichtung einerseits an die High Side-Schalteinrichtung und andererseits an den zweiten Pol angeschlossen ist, wobei die High Side-Schalteinrichtung und die Low Side-Schalteinrichtung jeweils einen Leistungsschalter mit einem Schalteingang, einem Leistungseingang und einem Leistungsausgang aufweisen, und wobei der Leistungseingang und der Leistungsausgang bei geschlossenem Leistungsschalter elektrisch miteinander verbunden und bei geöffnetem Leistungsschalter elektrisch getrennt sind. Dabei ist wiederum vorgesehen, dass der Schalteingang des Leistungsschalters der High Side-Schalteinrichtung und/oder der Low Side-Schalteinrichtung sowohl an eine Steuerschaltung als auch an eine Zwischenkreisspannungsbegrenzungsschaltung angeschlossen ist, die den Leistungsschalter beim Überschreiten eines Spannungsgrenzwerts durch eine Zwischenkreisspannung in dem Zwischenkreis schließt.

Auch hinsichtlich des Verfahrens und/oder des dem Verfahren zugrunde liegenden Wechselrichters können die vorstehenden Ausführungen für vorteilhafte Weiterbildungen herangezogen werden. Entsprechend wird erneut auf diese verwiesen.

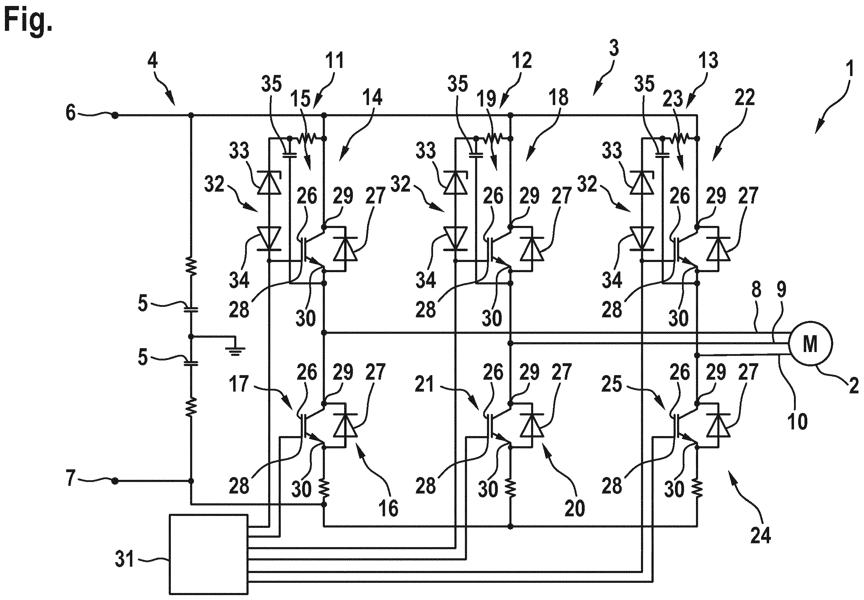

Die Erfindung wird nachfolgend anhand der in der Zeichnung dargestellten Ausführungsbeispiele näher erläutert, ohne dass eine Beschränkung der Erfindung erfolgt. Dabei zeigt die einzige
- Figur: eine schematische Darstellung einer Schaltungsanordnung, die eine elektrische Maschine sowie einen Wechselrichter zur Ansteuerung der elektrischen Maschine aufweist.

Die Figur zeigt eine schematische Darstellung einer Schaltungsanordnung 1. Diese weist eine elektrische Maschine 2 sowie einen Wechselrichter 3 auf, der zum Betreiben der elektrischen Maschine 2 dient. Über den Wechselrichter 3 ist die elektrische Maschine 2 mit einem Zwischenkreis 4 verbunden, an welchen beispielsweise auch ein Energiespeicher und/oder ein Bordnetz eines Kraftfahrzeugs (hier nicht dargestellt) angeschlossen sind. In dem Zwischenkreis 4 kann wenigstens ein Zwischenkreiskondensator 5 (hier: zwei zwischen Kreiskondensatoren 5) vorgesehen sein. Der Zwischenkreis 4 kann wenigstens teilweise Bestandteil des Wechselrichters 3 bilden. Der Zwischenkreis 4 weist einen ersten elektrischen Pol 6 und einen zweiten elektrischen Pol 7 auf. Die beiden Pole 6 und 7 verfügen über unterschiedliche elektrische Potentiale. Beispielsweise ist der erste Pol 6 als Pluspol und der zweite Pol 7 als Minuspol ausgebildet.

Der Zwischenkreis 4 wird mit Gleichstrom betrieben, welcher beispielsweise dem Energiespeicher entnommen wird. Die elektrische Maschine 2 ist jedoch eine Wechselstrommaschine beziehungsweise Drehstrommaschine. Entsprechend weist sie Phasenanschlüsse 8, 9 und 10 auf. Beispielsweise liegt die elektrische Maschine als Asynchronmaschine vor. Der Wechselrichter 3 dient dazu, den Gleichstrom des Zwischenkreises 4 in einen Wechselstrom beziehungsweise Drehstrom umzusetzen und der elektrischen Maschine 2 über die Phasenanschlüsse 8, 9 und 10 bereitzustellen. Umgekehrt kann selbstverständlich mit Hilfe des Wechselrichters 3 auch in einem generatorischen Betrieb der elektrischen Maschine 2 anfallender Wechselstrom beziehungsweise Drehstrom in Gleichstrom umgesetzt und dem Zwischenkreis 4 zugeführt werden.

Der Wechselrichter 3 weist mehrere Phasensysteme, in dem hier dargestellten Ausführungsbeispiel drei Phasensysteme 11, 12 und 13 auf. Das Phasensystem 11 verfügt über eine High Side-Schalteinrichtung 14 mit einem Leistungsschalter 15 und über eine Low Side-Schalteinrichtung 16 mit einem Leistungsschalter 17. Das Phasensystem 12 verfügt über eine High Side-Schalteinrichtung 18 mit einem Leistungsschalter 19 und eine Low Side-Schalteinrichtung 20 mit einem Leistungsschalter 21. Das Phasensystem 13 schließlich verfügt über eine High Side-Schalteinrichtung 22 mit einem Leistungsschalter 23 sowie eine Low Side-Schalteinrichtung 24 mit einem Leistungsschalter 25. Jeder der Leistungsschalter 15, 17, 19, 21, 23 und 25 besteht aus einem Leistungstransistor 26 sowie einer Diode 27, welche bevorzugt als Freilaufdiode vorliegt. Jeder der Leistungsschalter 15, 17, 19, 21, 23 und 25 verfügt zudem über einen Schalteingang 28, einen Leistungseingang 29 sowie einen Leistungsausgang 30.

Jeder der Schalteingänge 28 ist mit einer Steuerschaltung 31 elektrisch verbunden. Mit Hilfe der Steuerschaltung 31 werden die Leistungsschalter 15, 17, 19, 21, 23 und 25 beziehungsweise die entsprechenden Leistungstransistoren 26 angesteuert, um entweder den Gleichstrom des Zwischenkreises 4 in Wechselstrom beziehungsweise Drehstrom für die elektrische Maschine 2 umzusetzen oder umgekehrt den Wechselstrom beziehungsweise Drehstrom der elektrischen Maschine 2 in Gleichstrom für den Zwischenkreis 4.

Zusätzlich ist es nun vorgesehen, dass den Leistungsschaltern 15, 17 und 19 der High Side-Schalteinrichtungen 14, 16 und 18 jeweils eine Zwischenkreisspannungsbegrenzungsschaltung 32 zugeordnet ist. Diese weist eine Z-Diode 33 sowie eine Diode 34 auf, die miteinander in Reihe geschaltet sind. Insbesondere ist eine Kathode der Z-Diode 33 mit dem jeweiligen Leistungseingang 29 des entsprechenden Leistungsschalters 15, 17 beziehungsweise 19 verbunden, während eine Anode der Z-Diode 33 über die Diode 34 mit dem entsprechenden Schalteingang 28 verbunden ist. Weiterhin ist jedem der Leistungsschalter 15, 17 und 19 eine Kapazität 35 parallel geschaltet. Diese arbeitet als Filter, insbesondere als Tiefpassfilter.

Neben den hier gezeigten Elementen der Schaltungsanordnung 1 weist diese zahlreiche nicht näher gekennzeichnete Induktivitäten auf. Diese können, müssen jedoch nicht vorhanden sein. In dem hier dargestellten Fall dienen sie lediglich der Darstellung von parasitären Induktivitäten. Alternativ zu der hier gezeigten Darstellung können die Zwischenkreisspannungsbegrenzungsschaltungen 32 anstelle den High Side-Schalteinrichtungen 18, 18 und 22 den Low Side-Schalteinrichtungen 16, 20 und 24 zugeordnet sein.

Die Zwischenkreisspannungsbegrenzungsschaltung 32 dient der Begrenzung einer in dem Zwischenkreis 4 vorliegenden Zwischenkreisspannung. Diese kann beispielsweise stark ansteigen, falls die elektrische Maschine 2 generatorisch betrieben wird und in dem Zwischenkreis 4 kein ausreichend dimensionierter elektrischer Verbraucher, beispielsweise in Form eines Bordnetzes des Kraftfahrzeugs und/oder dem Energiespeicher, zu Verfügung steht. Dennoch soll auch in diesem Fall der Wechselrichter 3 zunächst normal weiterbetrieben werden, also mit Hilfe der Steuerschaltung 31 die Phasensysteme 11, 12 und 13 zum Wechselrichten beziehungsweise Gleichrichten angesteuert werden. Zudem ist eine Zenerspannung der Z-Dioden 33 gleich eines Spannungsgrenzwerts für die Zwischenkreisspannung gewählt.

Überschreitet nun die Zwischenkreisspannung diesen Spannungsgrenzwert, so werden die Z-Dioden 33 leitend, sofern gleichzeitig die Low Side-Schalteinrichtung 16, 20 beziehungsweise 24 des entsprechend Phasensystems 11, 12 beziehungsweise 13 leitend beziehungsweise der entsprechende Leistungsschalter 17, 21 beziehungsweise 25 geschlossen ist. Bei durchgängiger Z-Diode 33 wird der Schalteingang 28 des entsprechenden Leistungsschalters 15, 19 beziehungsweise 23 mit einer Spannung beziehungsweise einem Strom beaufschlagt, sodass er schließt.

Entsprechend liegt in diesem Fall ein Kurzschluss der Pole 6 und 7 des Zwischenkreises 4 über das entsprechende Phasensystem 11, 12 beziehungsweise 13 vor, sodass die in dem Zwischenkreis 4 vorliegende Überspannung über das Phasensystem 11, 12 beziehungsweise 13 abgebaut wird. Weil der Abbau der Überspannung sehr rasch geschieht und nach erneutem Unterschreiten des Spannungsgrenzwerts durch die Zwischenkreisspannung die zuvor durchgängige Z-Diode 33 erneut sperrt, kann keine Beschädigung des Wechselrichters 3 auftreten.

## Patentansprüche

1. Wechselrichter (3) für eine elektrische Maschine (2), der an einen über einen ersten elektrischen Pol (6) und einen zweiten elektrischen Pol (7) verfügenden Zwischenkreis (4) angeschlossen ist und über mehrere Phasensysteme (11,12,13) verfügt, die jeweils eine High Side-Schalteinrichtung (14,18,22) und eine Low Side-Schalteinrichtung (16,20,24) aufweisen, wobei die High Side-Schalteinrichtung (14,18,22) einerseits an den ersten Pol (6) und andererseits an die Low Side-Schalteinrichtung (16,20,24) angeschlossen und die Low Side-Schalteinrichtung (16,20,24) einerseits an die High Side-Schalteinrichtung (14,18,22) und andererseits an den zweiten Pol (7) angeschlossen ist, wobei die High Side-Schalteinrichtung (14,18,22) und die Low Side-Schalteinrichtung (16,20,24) jeweils einen Leistungsschalter (15,17,19,21,23,25) mit einem Schalteingang (28), einem Leistungseingang (29) und einem Leistungsausgang (30) aufweisen, und wobei der Leistungseingang (29) und der Leistungsausgang (30) bei geschlossenem Leistungsschalter (15,17,19,21,23,25) elektrisch miteinander verbunden und bei geöffnetem Leistungsschalter (15,17,19,21,23,25) elektrisch getrennt sind, **dadurch gekennzeichnet, dass** der Schalteingang (28) des Leistungsschalters (15,17,19,21,23,25) der High Side-Schalteinrichtung (14,18,22) und/oder der Low Side-Schalteinrichtung (16,20,24) sowohl an eine Steuerschaltung (31) als auch an eine Zwischenkreisspannungsbegrenzungsschaltung (32) angeschlossen ist, die den Leistungsschalter (15,17,19,21,23,25) beim Überschreiten eines Spannungsgrenzwerts durch eine Zwischenkreisspannung in dem Zwischenkreis (4) schließt.

2. Wechselrichter nach Anspruch 1, **dadurch gekennzeichnet, dass** die Zwischenkreisspannungsbegrenzungsschaltung (32) eine Z-Diode (33) und eine Diode (34) aufweist, wobei eine Kathode der Z-Diode (33) an den Leistungseingang (29) und eine Anode der Z-Diode (33) über die Diode (34) an den Schalteingang (28) des jeweiligen Leistungsschalters (15,17,19,21,23,25) angeschlossen ist.

3. Wechselrichter nach einem der vorhergehenden Ansprüche, **dadurch gekennzeichnet, dass** die Zenerspannung der Z-Diode (33) dem Spannungsgrenzwert entspricht.

4. Wechselrichter nach einem der vorhergehenden Ansprüche, **dadurch gekennzeichnet, dass** dem Leistungsschalter (15,17,19,21,23,25) eine Kapazität (35) parallel geschaltet ist.

5. Wechselrichter nach einem der vorhergehenden Ansprüche, **dadurch gekennzeichnet, dass** der Leistungsschalter (15,17,19,21,23,25) einen Leistungstransistor (26) und eine dem Leistungstransistor (26) parallel geschaltete Diode (27) aufweist.

6. Wechselrichter nach einem der vorhergehenden Ansprüche, **dadurch gekennzeichnet, dass** der Zwischenkreis (4) wenigstens einen Zwischenkreiskondensator (5) aufweist, über den der erste elektrische Pol (6) mit dem zweiten elektrischen Pol (7) elektrisch verbunden ist.

7. Wechselrichter nach einem der vorhergehenden Ansprüche, **dadurch gekennzeichnet, dass** das Schließen des Leistungsschalters (15,17,19,21,23,25) aufgrund des Überschreitens des Spannungsgrenzwerts auf eine bestimmte Zeitspanne begrenzt ist.

8. Wechselrichter nach einem der vorhergehenden Ansprüche, **dadurch gekennzeichnet, dass** eine Schließzeit des Leistungsschalters (15,17,19,21,23,25) mittels der Steuerschaltung (31) überwacht und/oder begrenzt ist.

9. Elektrische Antriebseinrichtung für ein Kraftfahrzeug, mit einer elektrischen Maschine (2) und einem Wechselrichter (3) zur Ansteuerung der elektrischen Maschine (2), **dadurch gekennzeichnet, dass** der Wechselrichter (3) nach einem oder mehreren der vorhergehenden Ansprüche ausgestaltet ist.

10. Verfahren zum Betreiben eines Wechselrichters (3) für eine elektrische Maschine (2), insbesondere eines Wechselrichters (3) nach einem oder mehreren der vorhergehenden Ansprüche, wobei der Wechselrichter (3) an einen über einen ersten elektrischen Pol (6) und einen zweiten elektrischen Pol (7) verfügenden Zwischenkreis (4) angeschlossen ist und mehrere Phasensystemen (11,12,13) aufweist, die jeweils über eine High Side-Schalteinrichtung (14,18,22) und eine Low Side-Schalteinrichtung (16,20,24) verfügen, wobei die High Side-Schalteinrichtung (14,18,22) einerseits an den ersten Pol (6) und andererseits an die Low Side-Schalteinrichtung (16,20,24) angeschlossen und die Low Side-Schalteinrichtung (16,20,24) einerseits an die High Side-Schalteinrichtung (14,18,22) und andererseits an den zweiten Pol (7) angeschlossen ist, wobei die High Side-Schalteinrichtung (14,18,22) und die Low Side-Schalteinrichtung (16,20,24) jeweils einen Leistungsschalter (15,17,19,21,23,25) mit einem Schalteingang (28), einem Leistungseingang (29) und einem Leistungsausgang (30) aufweisen, und wobei der Leistungseingang (29) und der Leistungsausgang (30) bei geschlossenem Leistungsschalter (15,17,19,21,23,25) elektrisch miteinander verbunden und bei geöffnetem Leistungsschalter (15,17,19,21,23,25) elektrisch getrennt sind, **dadurch gekennzeichnet, dass** der Schalteingang (28) des Leistungsschalters (15,17,19,21,23,25) der High Side-Schalteinrichtung (14,18,22) und/oder der Low Side-Schalteinrichtung (16,20,24) sowohl an eine Steuerschaltung (31) als auch an eine Zwischenkreisspannungsbegrenzungsschaltung (32) angeschlossen ist, die den Leistungsschalter (15,17,19,21,23,25) beim Überschreiten eines Spannungsgrenzwerts durch eine Zwischenkreisspannung in dem Zwischenkreis (4) schließt.
